(19) Europäisches Patentamt
European Patent Office
Office européen des brevets

(11) **EP 3 461 928 B1**

(12) **EUROPEAN PATENT SPECIFICATION**

(45) Date of publication and mention
of the grant of the patent:
**11.11.2020 Bulletin 2020/46**

(51) Int Cl.:
*C23C 16/30* (2006.01)          *C23C 16/36* (2006.01)
*C23C 16/448* (2006.01)        *C23C 16/455* (2006.01)
*C23C 16/02* (2006.01)          *C23C 28/04* (2006.01)
*C23C 16/32* (2006.01)          *C04B 41/87* (2006.01)
*C04B 41/00* (2006.01)          *C04B 41/50* (2006.01)
*C23C 16/52* (2006.01)

(21) Application number: **17194005.9**

(22) Date of filing: **29.09.2017**

(54) **TACNO COATINGS AND PRODUCTION PROCESS**

TACNO-BESCHICHTUNGEN UND HERSTELLUNGSVERFAHREN

REVÊTEMENTS TACNO ET PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**03.04.2019 Bulletin 2019/14**

(73) Proprietors:
• **WALTER AG
72072 Tübingen (DE)**
• **Fraunhofer-Gesellschaft zur Förderung der angewandten Forschung e.V.
80686 München (DE)**

(72) Inventors:
• **STIENS, Dirk
72076 Tübingen (DE)**
• **ENDLER, Ingolf
01640 Coswig (DE)**
• **HÖHN, Mandy
01705 FREITAL (DE)**

(74) Representative: **Sandvik
Sandvik Intellectual Property AB
811 81 Sandviken (SE)**

(56) References cited:
**EP-A1- 1 852 407       WO-A1-99/24634
US-A- 4 138 512**

• **LONG YING ET AL: "The effect of deposition temperature on the microstructure and mechanical properties of TaC coatings", MATERIALS LETTERS, vol. 121, 14 January 2014 (2014-01-14), pages 202-205, XP028626793, ISSN: 0167-577X, DOI: 10.1016/J.MATLET.2014.01.145**
• **ZHAO-KE CHEN ET AL: "Influence of TaClpartial pressure on texture structure of TaC coating deposited by chemical vapor deposition", APPLIED SURFACE SCIENCE, ELSEVIER, AMSTERDAM, NL, vol. 257, no. 9, 27 November 2010 (2010-11-27), pages 4044-4050, XP028152063, ISSN: 0169-4332, DOI: 10.1016/J.APSUSC.2010.11.172 [retrieved on 2010-12-04]**
• **ZHAO-KE CHEN ET AL: "Texture structure and ablation behavior of TaC coating on carbon/carbon composites", APPLIED SURFACE SCIENCE, vol. 257, no. 2, 24 July 2010 (2010-07-24), pages 656-661, XP028819016, ISSN: 0169-4332, DOI: 10.1016/J.APSUSC.2010.07.064**

**Description**

**FIELD OF THE INVENTION**

The present invention relates to a coated body, preferably a coated cutting tool, consisting of a substrate of cemented carbide, cermets, ceramics or cubic boron nitride and a single layer or multi-layer wear resistant coating preferably deposited by chemical vapor deposition (CVD), wherein the wear resistant coating comprises a tantalum containing hard material wear protection layer.

The present invention further relates to a method for the production of the coated body of the present invention by a CVD process using Ta chloride as a precursor in the reaction gas composition and using an external generator for the generation of the Ta chloride precursor.

**BACKGROUND OF THE INVENTION**

Cutting tools for chip forming metal machining consist of a substrate body of cemented carbide, cermets, ceramics, steel or cubic boron nitride that is usually coated with a single-layer or multi-layer hard coating to improve cutting properties and wear resistance. Most suitable hard coatings consist of polycrystalline mono-metallic or multi-metallic hard phases, however, hard coatings comprising amorphous phases are also known. The hard coatings usually consist of carbides, nitrides, oxides, borides or mixtures or solid solutions thereof of transition metals, Al, Si etc. Most suitable methods for the deposition of the hard coatings on the substrate are CVD or PVD methods.

Polycrystalline hard phase coatings deposited by CVD or PVD methods can be grown with strong preferential crystallographic orientation, also called fiber texture. In recent developments to improve cutting performance and wear resistance of coated cutting tools, CVD and PVD coatings have been grown with different preferential crystallographic orientations, i. e. fiber textures, each of which may yield favorable performance in different cutting operations due to the anisotropic properties of the coating materials.

Tantalum carbide is known to possess attractive properties, such as high melting point, high strength, high stiffness, and high temperature ductile behavior. TaC, TaN and TaCN layers are known to be used as diffusion barrier layers in microelectronics and as protective layers for carbon substrates, such as fibers. However, until now, there are no tantalum containing hard material wear resistant layers available on the market that are suitable as wear protection layers of cutting tools for chip forming metal machining. Nor is there an industrially suitable method for the production of such tantalum containing hard material layers available.

For the deposition of polycrystalline tantalum carbides, nitrides, oxides or mixtures thereof, herein generally referred to as "$TaC_xN_yO_z$" by chemical vapor deposition (CVD) it is required to provide a suitable tantalum precursor for the CVD reaction gas composition. The most generally used tantalum precursors for CVD include metallorganic compounds or tantalum halides such as $TaF_5$ or most commonly $TaCl_5$.

One disadvantage described in the literature of using metallorganic tantalum precursors for the deposition of tantalum containing coatings is the high reactivity and high carbon content of these compounds inevitably leading the incorporation of certain amounts of free carbon into the deposited coating layers, which impairs the usefulness of such coatings as hard wear resistant coatings due to high brittleness, low hardness and poor oxidation resistance.

Tantalum halides, such as $TaCl_5$, are solid at standard conditions. Therefore, when using tantalum chloride in the CVD process for the deposition of tantalum containing coatings, as it is described in the literature, these compounds must be heated to a certain temperature in order to generate tantalum chloride vapor and to obtain a suitable vapor pressure. However, reproducibility of the vaporization, and thus of the deposition process as such, to a large extent depends on the surface of the solid powder, and it occurs that solid powder particles are carried with the vapor into the reaction gas composition. Furthermore, the solid tantalum chloride must be treated with due care since it reacts with air moisture.

In order to overcome these problems going along with using solid tantalum chloride powder as a starting material, the tantalum chloride precursor vapor can be formed by chlorination of tantalum metal just prior to its introduction into the reaction chamber of the CVD reactor.

There exist essentially two established methods of tantalum chlorination, either by using chlorine (Cl2) or hydrogen chloride (HCl) as the chlorination agent. However, using chlorine gas in industrial applications requires complex and expensive safety systems due to the high toxicity of the chlorine and explosiveness in gas mixtures with hydrogen. Therefore, HCl is the better choice of chlorination agent.

Further, there exist two types of precursor generators for the CVD process, "internal" generators (internal chlorination reactors) that are integrated within the CVD reactor, and "external" generators (external chlorination reactors), wherein the precursors are generated in a separate system and are then carried into the CVD reaction chamber through pipes and valves.

"Internal" generators have the advantage that the generator site is in direct connection to the CVD chamber, which reduces the danger of a too early deposition of tantalum chloride or reaction products thereof to the equipment (pipes, valves etc.) and the danger of clogging the equipment and depletion of the vapor stream from precursor compound. Furthermore, using an internal generator there is less danger that the generated $TaCl_5$ reacts back by reduction into lower tantalum chlorides or even into tantalum metal before it reaches the CVD reaction chamber.

On the other hand, "internal" generators require complex handling, operation and service of the combined system. Furthermore, at any time the CVD system including the internal generator is opened to remove a batch of coated substrates and to reintroduce a new batch of uncoated substrates there is a danger of contaminating the tantalum charge. And, in an internal generator temperature and pressure cannot be freely adjusted independent from the temperature and pressure in the CVD reaction chamber. Moreover, internal generators usually provide no or only unreliable means to shut off the tantalum chloride charge from the gas fed into the reaction zone of the reactor. Therefore, the deposition of multilayer coatings is not viable with this setup, because other chloride precursor gases used in deposition of other coating compositions will react with the tantalum chloride charge and lead to cross contamination of layers.

"External" generators avoid the disadvantages associated with internal chlorinators. The separation of the generator from the CVD reactor facilitates safe and easy handling and service of both units in the combined system. The external reactor also allows for a reliable shut off the tantalum chloride charge from the precursor gas stream, which is a prerequisite for the deposition of multilayered coatings involving layers deposited from metal chloride precursors other than tantalum chloride, and therefore the external generator provides the flexibility needed for optimization of coating architectures and efficient deposition processes.

However, "external" generators have the disadvantage, as described above, that the pipes and valves connecting the generator to the CVD reaction chamber are prone to clogging due to the deposition of tantalum chloride or reaction products thereof from the precursor vapor. Also, using an external generator implies the danger that $TaCl_5$ reacts back by reduction into lower tantalum chlorides or even into tantalum metal before it reaches the CVD reaction chamber.

A. Levesque and A. Bouteville, J. Phys. IV France 11 (2001), p. Pr3-907-913, disclose investigations on the tantalum chlorination with hydrogen chloride for LPCVD (low pressure CVD) tantalum elaboration. In thermodynamic considerations and experiments, the generation of $TaCl_5$ and lower tantalum chlorides is investigated at 10 mbar and 40 mbar within the temperature range from 600-1300 K (327-1027°C). It was shown that the maximum molar fraction of $TaCl_5$ in the gas phase is obtained at about 550°C at 10 mbar and about 600°C at 40 mbar, where no or low $TaCl_{2.5}$ fraction occurs. However, at a generator temperature of about 600°C a steep increase of undesired $TaCl_{2.5}$ side-product was observed at a pressure > 50 mbar. At a generator temperature of about 670°C the onset of the steep increase of undesired $TaCl_{2.5}$ was at a pressure > 250mbar. The experiments were carried out in an external tantalum chloride generator made of quartz connected to the CVD reactor by a tube heated to about 150°C to avoid any tantalum chloride condensation.

There are two major disadvantages involved with the lab approach disclosed by Levesque and Bouteville, the low pressure and the high temperature required for the tantalum chloride generation.

Whereas the approach by Levesque and Bouteville is rather a scientific and theoretical one that can be realized in a small lab system, the range of process pressure for conventional LPCVD equipment is usually $\geq$ 50 mbar. Compared to these pressures reached in the LPCVD reactor, the chlorination pressures in the generator will always exceed the deposition pressure due to the back pressure caused by the flow resistance of the gas line between generator and reactor. Therefore, chlorination pressures as described by Levesque and Bouteville are difficult to reach in industrial equipment. And, even though higher pressures may be realizable at higher temperatures, external generators working at temperatures $\geq$ 600°C are difficult to build and operate due to lack of safe and corrosion resistant components. Standard equipment from commercial manufacturers are usually specified to temperatures of less than < 500°C. Process windows at > 600°C, as in the work by Levesque and Bouteville, are therefore hardly viable in industrial equipment.

A further drawback of the Ta chlorination method described by Levesque and Bouteville is using an external tantalum chloride generator made of a quartz tube. Quartz is not a suitable wall material for an industrial tantalum chloride generator. Generally, the generator should provide a high yield of $TaCl_5$ precursor, and this is only achieved if the chlorination temperature in the process using HCl is as low as possible. During the chlorination hydrogen is formed, and at temperatures higher than 600°C the formed hydrogen reduces a part of the $TaCl_5$ to lower chlorides or metallic tantalum. Additionally, decomposition of $TaCl_5$ to $TaCl_4$ and $Cl_2$ occurs. The applied pressures of the method described by Levesque and Bouteville at values below 40 mbar, or even at 10 mbar, are unfavorable for industrial LPCVD processes which work at pressures above 50 mbar.

Chen, Zhao-ke and Xiong, Xiang, "Texture structure and ablation behavior of TaC on carbon/carbon composites", Applied Surface Science, 257 (2010), 656-661, describe the CVD deposition of TaC coatings with different texture structures on carbon/carbon composites. The CVD process for the TaC deposition was carried out at a temperature of 900-1200°C and a pressure of about 200 Pa (2 mbar), and the reaction gas consisted of $Ar:C_3H_6:TaCl_5$ at a molar ratio of about 50:3:9. Three different kinds of Ta coatings with different colors (yellow, brown and grey), different crystal structures and different textures were obtained and investigated. The nano-indentation hardnesses of the coatings varied within the range from 13.7 GPa to 21.2 GPa (corresponding to a Vickers hardness in the order of about 1400 to 2160 HV).

Chen, Zhao-ke, Xiong, Xiang and Long, Ying, "Influence of TaCl5 partial pressure on texture structure of TaC coating deposited by chemical vapor deposition", Applied Surface Science, 257 (2011), 4044-4050, describe the influence of $TaCl_5$ partial pressure on deposition rate, composition, surface morphology and texture structure of the TaC coatings deposited by CVD on graphite substrates using the reaction gas system consisting Ar, $C_3H_6$, and $TaCl_5$, as described above. The Ta source was a solid $TaCl_5$ powder that was vaporized at elevated temperatures. The depositions were carried out at 800°C and 1200°C, respectively, at $TaCl_5$ partial pressures of 3.4%, 6.6%, 9.6% and 12.4%, respectively. The TaC coatings exhibited a preferred (200) texture, whereby at 1200°C deposition temperature the (200) texture decreased and the (220) texture increased at increasing $TaCl_5$ partial pressure. At 800°C the influence of the partial pressure on surface morphology and microstructure of the coating was very low, and a very loose coating with ball-shaped grains and with lots of pores was obtained. At 1200°C the influence of the partial pressure on surface morphology and microstructure of the coating was very large leading to phase mixtures at higher $TaCl_5$ partial pressures.

Similar studies were carried out earlier by Chen, Zhao-ke et al., "Phase composition and morphology of TaC coating on carbon fibers by chemical vapor infiltration", Thin Solid Films, 516, 2008, 8248-8254. The CVD deposition conditions were very similar to the ones applied later in the above cited publication of 2011, and it turned out that, depending on the deposition conditions, the obtained coatings comprise phase mixtures of TaC, $Ta_2C$ and/or C. Generally, in the CVD coating of carbides the phase composition is affected by a carbon-containing substrate. In the CVD process applied by Chen, Zhao-ke et al. there are two carbon sources for the film formation, the gaseous hydrocarbon $C_3H_6$, as well as the carbon of the substrate. Therefore, other substrates, such as cemented carbides, cermets or ceramics, which are used for the preparation of cutting tools, require different CVD conditions. Some of the coatings prepared by Chen, Zhao-ke et al. contain a high content of crystalline carbon, which is undesired, because it lowers the oxidation resistance and the mechanical properties of the coatings. At 850°C the coating prepared by Chen, Zhao-ke et al. is a conglomeration of fine-grained particles, and at 950°C the coating is coarse-grained. In the work of Chen, Zhao-ke et al. there are no data about the chlorine content and the hardness of the coatings.

In general, preparing the coatings of Chen, Zhao-ke et al. on carbon substrate leads to a mismatch of the coefficient of expansion between the substrate material and the coating, which is generally undesired for tool coatings, because it leads to bad adhesion of the coating and undesired residual stresses and crack formation in the coatings.

The microstructural and morphological properties, the presence of several phases and the mechanical properties of the TaC coatings described by Chen, Zhao-ke et al. seem to be the result of the applied methods. Whereas these TaC coatings by Chen, Zhao-ke et al. appear to be suitable as reinforcing or barrier coatings on carbon composite or graphite substrates, they are, however, not suitable as wear resistant coating layers on cutting tools for metal machining, especially due to low hardness, porosity etc. EP1852407 A1 describes a tantalum carbide coated carbon material and a method of manufacturing that coated substrate. WO 99/24634 describes a PVD coated cutting tool comprising a multilayer coating. Zhao-Ke et al (Applied Surface Science vol. 257) and Ying Long et al (Materials letters, vol. 121) disclose CVD methods for depositing TaC coatings on substrates. US 4138512 describes CVD methods of deposition of TaW based coatings.

## OBJECT OF THE INVENTION

Therefore, it is an object of the present invention to provide a coated cutting tool according to claim 1, consisting of a substrate of cemented carbide, cermets, ceramics, or cubic boron nitride and a single layer or multi-layer wear resistant coating preferably deposited by chemical vapor deposition (CVD), wherein the wear resistant coating comprises a tantalum containing hard material layer providing, compared to the prior art, improved wear resistance, higher hardness, good oxidation resistance, and improved adhesion of the coating on the substrate.

It is another object of the present invention is to provide an improved method for the production of the coated cutting tool of claim 1.

## DESCIPTION OF THE INVENTION

To solve the above objects, the present invention provides a coated cutting tool, consisting of a substrate of cemented carbide, cermets, ceramics, or cubic boron nitride and a single layer or multi-layer wear resistant coating and having a total thickness from 1 to 25 $\mu$m, wherein the wear resistant coating comprises a tantalum containing hard material layer comprising one single phase or more than one phase of tantalum compounds represented by the general formula $Ta_wC_xN_yO_z$ with w = 1 or 2, $0.2 \leq x \leq 1.1$, $0 \leq y \leq 0.55$ and $0 \leq z \leq 0.2$, x+y+z being within the range from 0.8 - 1.2, and having a hardness of more than 2500 HV [0.01] and less than 3500 HV[0.01].

As it is used herein, the term TaCNO, if not otherwise specified, means the inventive tantalum coating as defined herein and as also designated by the formula "$Ta_wC_xN_yO_z$".

As described above, tantalum carbides and tantalum carbonitrides were generally known to possess attractive properties, such as high melting point, high strength, high stiffness, and high temperature ductile behavior. However, the properties of tantalum carbides obtained according to the prior art were insufficient for wear resistant coatings of cutting tools for the metal machining. The present invention provides, for the first time, TaCNO coatings exhibiting improved properties making the coating suitable as a coating layer of cutting tools. The TaCNO coating of the present invention provides high wear resistance for the metal machining, high hardness between 2500 HV and 3500 HV, good oxidation resistance, as well as improved adhesion of the coating to the substrate. The high adhesion and wear resistance of the inventive coatings was shown by scratch test investigations. An inventive TaCNO coating with a hardness of more than 2500 HV[0.01] was shown to be stable in the scratch test up to a load of 60 N, whereas a comparative TaCN coating with a low hardness of 1530 HV failed already at 18 N. Preferably, the coated cutting tool is prepared according to the process described herein.

A good oxidation resistance of TaC or $Ta_2C$, in general, was known from powder material investigations of more or less pure TaC material. Stochiometric cubic TaC as well as $Ta_2C$ starts only to oxidize above 700°C. However, as described above, prior art TaC coatings prepared by CVD processes suffered from the problem of the incorporation of carbon making such coatings prone to oxidation.

It was found that the advantageous properties of the coating, as described herein, were obtained by the process of the present invention. Even though, TaC coatings were known from the prior art, the hardness of such known TaC coatings was rather low, and the inventive hardness of more than 2500 HV [0.01] could not be reached. The inventors have found that the high hardness of the inventive coatings could be obtained by a thermal CVD coating process at a temperature between 725°C and 1050°C and at a pressure lower than 0.6 bar and from a reaction gas mixture containing at least $TaCl_5$, $H_2$ and/or noble gas, preferably Ar, and one or more selected from hydrocarbons, organic nitriles and oxygen-containing compounds, preferably selected from $CH_4$, $C_2H_4$, $C_2H_6$, $CH_3CN$, CO and $CO_2$. Preferably, the reaction gas mixture further contains HCl. Further preferably, the pressure in the thermal CVD coating process is at least 30 mbar, more preferably at least 40 mbar.

In a preferred embodiment of the invention, the tantalum containing hard material layer has a chlorine content < 3 at-%, preferably between 0.01 at-% and 3 at-%, and/or the tantalum containing hard material layer has a hydrogen content < 5 at-%. It was found that a low chlorine content and a low hydrogen content of the inventive TaCNO coating results in improved hardness above 2500 HV, high fracture resistance and an overall stability of the coating, as it is required for metal cutting tools. If a too high amount of chlorine, such as a chlorine content > 3 at-%, is incorporated into the TaCNO coating the hardness, crystallinity and texture of the coating will be deteriorated. If the hydrogen content is too high, such as > 5 at-%, Ta hydride phases, which can be represented by the general formula $TaH_x$, such as $TaH_{0.1}$ or $TaH_{0.5}$, will appear in amounts drastically deteriorating the hardness of the coating.

Therefore, in a further preferred embodiment of the inventive tantalum containing hard material layer the $TaH_x$ content is < 15 wt%, preferably < 10 wt%, more preferably < 5 wt%. A low $TaH_x$ content of the TaCNO coating of the present invention results in reduced porosity and brittleness of the coating compared to prior art coatings, and thus in improved hardness, fracture resistance and overall stability of the coating, as it is required for metal cutting tools.

It was also found that the properties of the inventive tantalum containing hard material layer could be further improved if, the content of free carbon, which is usually present in amorphous form, in the layer is < 5 wt-%, preferably < 3 wt-%, more preferably < 1 wt-%. The low content of free carbon can be obtained by the inventive process for manufacturing the TaCNO coating of the present invention. The low carbon content of TaCNO coating results in reduced porosity and brittleness of the coating compared to prior art coatings, and thus in improved hardness, fracture resistance and oxidation resistance, as well as in improved tribological behaviour, as it is required for metal cutting tools. If the content of amorphous carbon is too high, the hardness of the inventive coating of more than 2500 HV[0.01] may not be reached.

According to the present invention, the at least one of the $Ta_wC_xN_yO_z$ phases of the tantalum containing hard material layer contains no oxygen or a small amount of oxygen, defined by $0 \leq z \leq 0.2$. In one preferred embodiment, the TaCNO coating contains essentially no oxygen with z=0, whereby "no oxygen" means in the sense of the present invention that the oxygen content is below the detection limit of the WDX method described herein below.

However, depending on the overall composition of the inventive TaCNO coating, a certain small amount of oxygen has been shown to improve the hardness of the coating. Therefore, in another embodiment at least one of the $Ta_wC_xN_yO_z$ phases of the tantalum containing hard material layer contains oxygen with $0 < z \leq 0.2$, preferably $0.05 \leq z \leq 0.2$, more preferably $0.1 \leq z \leq 0.2$. However, if the oxygen content exceeds z = 0.2, then a hardness reduction was observed.

In an embodiment of the present invention, the tantalum containing hard material layer one or more tantalum carbide phases $Ta_wC_xN_yO_z$ with y = 0 and z = 0 and/or one or more tantalum carbonitride phases $TaC_xN_yO_z$ with y > 0 and z = 0.

In a specific embodiment of the present invention, the tantalum containing hard material layer contains or consists of two tantalum carbide phases $Ta_wC_xN_yO_z$ with y = 0 and z = 0, preferably a TaC phase and a $Ta_2C$ phase. In this embodiment no texture was measured for the two phases. The coatings of this embodiment show an outstanding hardness more than 2600HV or more than 2700HV and up to 3500 HV.

In another preferred embodiment of the present invention, the tantalum containing hard material layer contains or consists of one or more tantalum carbide phases $Ta_wC_xN_yO_z$ having a (200) texture [with a preferred crystal growth orientation of the {200} plane preferentially growing parallel to the substrate surface], or a (110) texture [with a preferred crystal growth orientation of the {110} plane preferentially growing parallel to the substrate surface].

In a specifically preferred embodiment thereof, the tantalum containing hard material layer contains or consists of a cubic TaC phase having a (200) texture. The coatings of this embodiment show an outstanding hardness more than 2600HV or more than 2700HV and up to 3500 HV.

In another specifically preferred embodiment thereof, the tantalum containing hard material layer contains or consists of a hexagonal $Ta_2C$ phase having a (110) texture. The coatings of this embodiment show an outstanding hardness more than 2600HV or more than 2700HV and up to 3500 HV.

In yet another specifically preferred embodiment thereof, the tantalum containing hard material layer contains or consists of a cubic TaCN phase having a (220) texture. The coatings of this embodiment show an outstanding hardness more than 2600HV or more than 2700HV and up to 3500 HV.

As described above, the hardness of the tantalum containing hard material layer of the present invention is more than 2500 HV [0.01]. However, even more preferred is a hardness of more than 2600HV[0.01] or even more than 2700HV [0.01]. Also, the upper limit of the hardness is preferably 3500HV [0.01].

In another preferred embodiment of the present invention, the tantalum containing hard material layer is a multi-layer system consisting of individual sub-layers of $Ta_wC_xN_yO_z$ phases having different stoichiometric coefficients of x, y and z. In this embodiment several sub-layers are deposited on top of each other forming a sub-layer stack, allowing to adapt or set the properties of the tantalum containing hard material layer by selecting or adjusting the individual sub-layers according to desired properties. The multi-layer structure has the advantage to reduce the danger of crack propagation in the coating. Further, it has been found that a multi-layer structure of the inventive type having an outer layer that is rich in carbon content is useful to improve the tribologic properties of the coating. The multi-layer structure further allows for the preparation of coating structures with a hardness gradient, which in turn may be suitable to improve the wear resistance and cutting properties for specific metal machining applications, for example by providing higher hardness in the outer region and lower hardness in the inner region of the coating may provide an advantageous compromise of hardness and toughness within the coating to improve wear resistance.

The tantalum containing hard material layer can be the sole hard material coating layer deposited on the substrate. However, preferably the tantalum containing hard material layer is combined in a multi-layer coating system with one or more further hard material layers above the tantalum containing hard material layer and/or between the substrate and the tantalum containing hard material layer, wherein the layers of the multilayer coating consist of one or more carbides, nitrides, oxides, borides or combinations or solid solutions thereof of transition metals selected from one or more of the elements of groups 4 to 6 of the periodic table and/or Al or Si.

Specifically, for example, TiN and/or MT-CVD TiCN layers arranged between the substrate and the tantalum containing hard material layer are suitable to improve the adhesion of the TaCNO layer, and outer layers of, for example, $Al_2O_3$ may be suitable to improve the wear resistance of the coating for specific metal machining operations.

It has been found that the tantalum carbides of the present invention exhibit very good adhesion to the substrate, especially if directly deposited to the surface of WC-Co cemented carbides. It is assumed that the improved adhesion is due to or influenced by the thermal expansion coefficient of the inventive tantalum carbide coating in the order of about 6 to 6.5 x $10^{-6}$ $K^{-1}$, which is closer to the thermal expansion coefficient of cemented carbides of about 4.5 - 5 x $10^{-6}$ $K^{-1}$ than the thermal expansion coefficients of common hard coating materials, such as TiN, TiC, TiCN or $Al_2O_3$. It is assumed that this match or closeness of the thermal expansion coefficient of the tantalum carbide to the one of the substrate avoids crack formation and debonding of the coating from the substrate at high temperature and/or temperature variations occurring during metal cutting operations.

The present invention also includes a method for the production of a coated cutting tool as defined herein and described above. In the method of the present invention the tantalum containing layer is deposited by a thermal CVD process at a temperature between 725°C and 1050°C, at a pressure lower than 600 mbar, and from a reaction gas mixture that contains at least $TaCl_5$, $H_2$ and/or noble gas, preferably Ar, and one or more selected from hydrocarbons, organic nitriles and oxygen-containing compounds, preferably selected from $CH_4$, $C_2H_4$, $C_2H_6$, $CH_3CN$, CO and $CO_2$. Preferably, the reaction gas mixture further contains HCl. Further preferably, the pressure in the thermal CVD coating process is at least 30 mbar, more preferably at least 40 mbar.

The amounts of the components of the CVD reaction gas mixture according to the invention are:

- $TaCl_5$ in an amount of 0.2 to 4 vol-%,
- HCl in an amount of 0 to 8 vol-%,
- noble gas, preferably Ar, in an amount of 0 to 75 vol-%,
- one or more the hydrocarbons, organic nitriles and/or oxygen-containing compounds in an amount of 0.03 to 10

vol-%, and

- balance $H_2$.

Preferably, if used, $CH_3CN$ is contained in the CVD reaction gas mixture in an amount of 0.03 to 0.3 vol-% and/or $C_2H_4$ is contained in the CVD reaction gas mixture in an amount of 0.05 to 2 vol-% and/or $C_2H_6$ and/or $CH_4$ are contained in the CVD reaction gas mixture in an amount of 0.5 to 10 vol-%.

In the inventive method of the present invention in the CVD reaction gas mixture the vol-% ratio of $H_2$ / $TaCl_5$ is in within the range of 20 to 800, preferably 30 to 500, more preferably 50 to 200. If the ratio of $H_2$ / $TaCl_5$ is too high, the hydrogen content in the coatings increases, and the hardness and stability of the coatings decreases.

In another embodiment of the inventive method of the present invention the CVD reaction gas mixture comprises $H_2$ and a noble gas, preferably Ar, wherein the vol-% ratio of $H_2$ / ($H_2$ + noble gas) is in within the range of 0.1 to 1.0.

In the inventive method of the present invention in the CVD reaction gas mixture

- $CH_4$ is selected as hydrocarbon and the vol-% ratio of $CH_4$ / ($CH_4$ + $TaCl_5$) is >0.5, preferably is within the range of 0.55 to 0.95, more preferably is within the range of 0.6 to 0.9, and/or
- the one or more hydrocarbons are selected from $C_2H_4$ and $C_2H_6$, and the vol-% ratio of hydrocarbons / (hydrocarbons + $TaCl_5$) is in within the range of 0.3 to 0.95, preferably 0.5 to 0.85, and/or
- the organic nitrile is $CH_3CN$, and the vol-% ratio of $CH_3CN$ / ($CH_3CN$ + $TaCl_5$) is in within the range of 0.1 to 0.5, and/or
- the one or more oxygen-containing compounds are selected from CO and $CO_2$, and the vol-% ratio of oxygen-containing compounds / (oxygen-containing compounds + $TaCl_5$) is in within the range of 0.05 to 0.9, preferably 0.2 to 0.7.

Particularly beneficial results were obtained applying the herein described CVD process method if the $TaCl_5$ precursor is produced in an external tantalum chloride generator by the reaction of tantalum metal with pure HCl or with a mixture of HCl and a noble gas, preferably Ar, at a temperature between 400°C and 600°C, preferably between 450 and 550 °C and at a process pressure of more than 40 mbar and less than 600 mbar.

Particular advantages of using an external $TaCl_5$ generator in the method of the present invention is that low temperature and low pressure can be applied to generate $TaCl_5$ with high yield, and the use of toxic and explosive $Cl_2$ gas for the generation of Ta chloride precursor can be avoided.

In a preferred embodiment of the method of the invention a proportion or all of the HCl contained in the CVD reaction gas mixture is added at the outlet (exit) of the tantalum chloride generator before the tantalum chloride precursor is mixed with the further constituents of the CVD reaction gas mixture.

## BRIEF DESCRIPTION OF THE FIGURES

Figure 1: XRD of the $TaC_xN_yO_z$ coating according to example 2. The coating consists of a cubic TaCN phase (PDF 01-074-5555) and exhibits a strong <220> fiber texture.

Figure 2: XRD of the $TaC_xN_yO_z$ coating according to example 3. The coating consists of a phase mixture of cubic TaCN phase (PDF 01-074-5555) and a hexagonal $Ta_2C$ phase (PDF 00-032-1280) and shows no texture.

Figure 3: XRD of the $TaC_xN_yO_z$ coating according to example 4. The coating has a crystalline phase of cubic TaCN (PDF 01-074-5555) having a strong (220) texture.

Figure 4: Raman spectrum of the $TaC_xN_yO_z$ coating according to example 4. In addition to the characteristic bands of TaCN, the spectrum further shows characteristic bands of amorphous or nanocrystalline graphitic carbon, respectively (D peak at 1362 cm-1, G peak at 1600 cm-1).

Figure 5: XRD of the $TaC_xN_yO_z$ coating according to example 5. The coating consists of a phase mixture of cubic TaC phase (PDF 00-035-0801) and hexagonal $Ta_2C$ phase (PDF 00-032-1280).

Figure 6: XRD of the $TaC_xN_yO_z$ coating according to example 6. The coating consists of a cubic TaC phase (PDF 00-035-0801) and exhibits a strong (200) texture.

Figure 7: Pole figure of the $TaC_xN_yO_z$ coating according to example 6 showing the strong (200) texture of the cubic TaC coating.

Figure 8:     XRD of the $TaC_xN_yO_z$ coating according to example 7. The coating consists only of hexagonal $Ta_2C$ phase (PDF 00-032-1280) and exhibits a strong (110) texture.

Figure 9:     XRD of the $TaC_xN_yO_z$ coating according to example 8. The coating consists of a phase mixture of hexagonal $Ta_2C$ phase (PDF 00-032-1280) and a low amount of cubic TaC phase (PDF 00-035-0801). The hexagonal $Ta_2C$ phase exhibits a strong (110) texture.

Figure 10:   XRD of the $TaC_xN_yO_z$ coating according to example 9. The coating consists of a phase mixture of hexagonal $Ta_2C$ phase (PDF 00-032-1280), cubic TaC phase (PDF 00-035-0801) and tetragonal $TaH_{0.5}$ phase (PDF 01-089-4074).

## DEFINITIONS, MATERIALS and METHODS

Fiber Texture

The term "fiber texture" or "texture", respectively, as used herein and as it is generally used in connection with thin films produced by vapor deposition, distinguishes the orientation of the grown grains from random orientation. Three types of textures are usually distinguished in thin films and coatings: (i) random texture, when grains have no preferred orientation; (ii) fiber texture, where the grains in the coating are oriented such that one set of geometrically equivalent crystallographic planes {hkl} is found to be preferentially oriented parallel to the substrate surface plane, while there is a rotational degree of freedom of the grains around the fiber axis which is perpendicular to this plane, and (iii) epitaxial alignment (or in-plane texture) on single-crystal substrates, where an in-plane alignment fixes all three axes of the grain with respect to the substrate. In the context of the present application, the term "texture" is used synonymously for "fiber texture", and a preferred orientation of the crystallographic {hkl} plane is indicated as "(hkl) texture".

The crystallographic plane of a crystal is defined by the Miller indices, h, k, l. A means to express preferred growth, i. e. that one set of geometrically equivalent crystallographic planes {h k l} is found to be preferentially oriented parallel to the substrate, is the texture coefficient TC (h k l) calculated using the Harris formula on the basis of a defined set of XRD reflections measured on the respective sample. The intensities of the XRD reflections are standardized using a JCPDF-card (herein also referred to as "PDF") indicating the intensities of the XRD reflections of the same material, e.g. TaC, but with random orientation, such as in a powder of the material. A texture coefficient TC (h k l) > 1 of a layer of crystalline material is an indication that the grains of the crystalline material are oriented with their {h k l} crystallographic plane parallel to the substrate surface more frequently than in a random distribution, at least compared to the XRD reflections used in the Harris formula to determine the texture coefficient TC.

$$TC_{(hkl)} = \frac{I_{(hkl)}/I_{0(hkl)}}{\frac{1}{n}\sum I_{(hkl)}/I_{0(hkl)}} \qquad \text{(Harris formula)}$$

XRD (X-ray diffraction)

XRD measurements were done with Bragg-Brentano configuration using a XRD7 diffractometer of Seifert FPM using $CuK\alpha$-radiation. Texture coefficients TC were calculated from the contained diffraction pattern. Pole figure measurement were done on a XRD3003 PTS diffractometer of GE Sensing and Inspection Technologies using $CuK\alpha$-radiation. The X-ray tube was run in point focus at 40 kV and 40 mA. A parallel beam optic using a polycapillary collimating lens with a measuring aperture of fixed size was used on the primary side whereby the irradiated area of the sample was defined in such manner that a spill over of the X-ray beam over the coated face of the sample is avoided. On the secondary side a Soller slit with a divergence of 0.4° and a 25 $\mu$m thick Ni $K_\beta$ filter were used.

EDX (Energy-dispersive X-ray spectroscopy)

EDX measurements were carried out on a scanning electron microscope Ultra 55 from Carl Zeiss at 15 kV acceleration voltage with an EDX spectrometer of the type X-Max 80 and the software AZtec 3.3 from Oxford Instruments, UK.

WDX (Wavelength-dispersive X-ray spectroscopy)

WDX measurements were carried out on a scanning electron microscope Ultra 55 from Carl Zeiss at 5 kV acceleration voltage with an WDX spectrometer of the type INCA-Wave and the software INCA 5.05 from Oxford Instruments, UK.

### Pole figures

Pole figures of a particular {hkl} reflection of the analysed layer were measured using XRD, as described herein, over an angle range of $0°\leq\alpha<80°$ (increment 5°) and $0°\leq\beta\leq360°$ (increment 5°) with a circular arrangement of the measurement points. For background correction of the measured intensities the background intensity was measured for each increment of $\alpha$ at a fixed $2\theta$ angle which does not overlap with diffraction peaks of any of the other coating layers or the substrate. No defocussing correction was applied. If the intensity distribution of all measured and back-calculated pole figures was approximately rotationally symmetrical, the investigated layer exhibited fibre texture.

### Microhardness

Vickers microhardness was measured on a microhardness device MHT 10 of Anton Paar using a load of 0.1 N. The herein indicated values are the average of five measurements. The hardness was measured on a calotte section in the top area of the investigated layer. The measurements were done according to DIN EN ISO 6507-1.

## EXAMPLES

In the following examples of the preparation of cutting tools according to the present invention and of comparative examples cemented carbide cutting tool substrate bodies (composition: 90.5 wt-% WC, 1.5 wt-% TaC + NbC and 8.0 wt-% Co; geometry: SEHW1204AFN) were coated in a cylindrical hot wall CVD reactor having an inner diameter of 75 mm.
The Ta containing coatings are generally referred to as "$TaC_xN_yO_z$ coating" with their specific composition and properties being further specified.

### Example 1

An inventive "external" generator was employed for generating the $TaCl_5$ used in the CVD depositions of $TaC_xN_yO_z$ coatings according to the present invention. The external generator was a stainless steel device equipped with two gas inlets for HCl and inert gas, respectively, and a further HCl gas feed line at the generator outlet. The generator was filled with tantalum chips. The amount of the vaporized $TaCl_5$ was determined by condensation in a trap at the outlet of the generator in dependence of the HCl inlet flow rate. A stable generation of $TaCl_5$ vapor was realized in a process window which is described in the following table.

Table 1: $TaCl_5$ generation in dependence on temperature and pressure of the generator

| Temp. | Pressure | | |
|---|---|---|---|
| | 40 mbar | 100 mbar | 1013 mbar |
| 450°C | stable $TaCl_5$ formation | nonlinear increase of $TaCl_5$ formation with increasing HCl flow | no formation of $TaCl_5$ |
| 500°C | stable $TaCl_5$ formation | stable $TaCl_5$ formation | no formation of $TaCl_5$ |
| 600°C | stable $TaCl_5$ formation | stable $TaCl_5$ formation | stable $TaCl_5$ formation |

In the following examples, the generator was operated in the range of the stable $TaCl_5$ formation for preparing the inventive $TaC_xN_yO_z$ coatings. Stable $TaCl_5$ formation means that the conversion of HCl to $TaCl_5$ was essentially complete, and the yield of $TaCl_5$ increases linearly with increasing amounts of supplied HCl.
EDX analysis (Energy-dispersive X-ray spectroscopy) was carried out on the Ta chips used to prepare the tantalum chloride precursor in the chloride generator to determine the purity of the Ta chips. In addition to the Ta peak, EDX showed a small oxygen peak corresponding to an O content in the Ta chips of about 1 at-%.

### Example 2

A coating according to the present invention was prepared on cemented carbide substrate bodies, as described above, by a CVD process using a reaction gas mixture of 0.44 vol-% $TaCl_5$, 0.13 vol-% $CH_3CN$, 0.43 vol-% CO, 1.1 vol-% HCl, 54.5 vol-% $H_2$ and 43.4 vol-% Ar, a temperature of 800°C and a pressure of 60 mbar for 90 min. The HCl content was added to the gas mixture at the outlet of the external $TaCl_5$ generator, which was operated at 500°C and 60 mbar.

The obtained TaCNO coating had a thickness of 8.5 $\mu$m.

WDX analysis of the deposited TaCNO coating layer showed a Ta content of 47.1 at-%, a C content of 28.4 at-%, a N content of 15.2 at-%, a O content of 7.3 at-%, and a Cl content of 2.0 at-%.

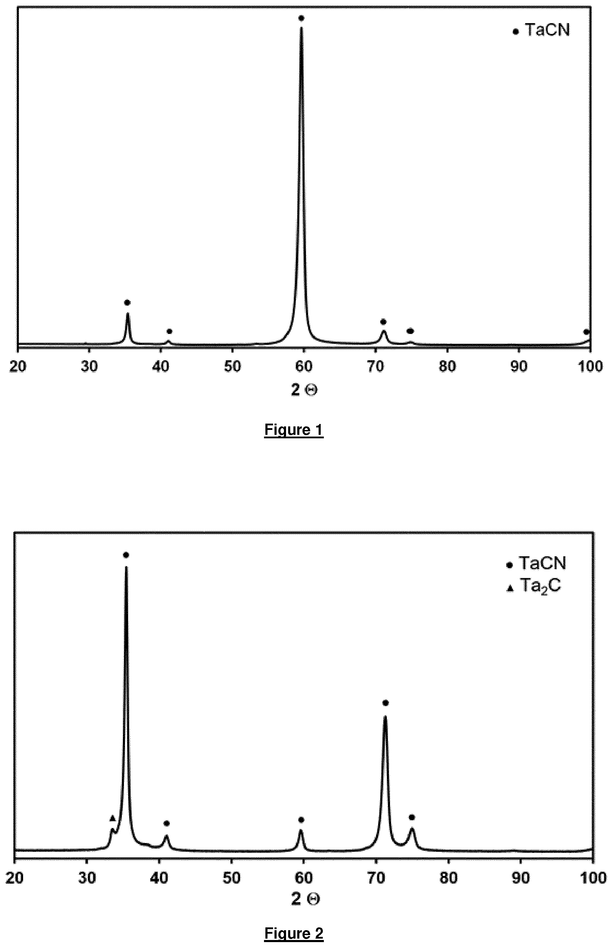

The XRD of the deposited TaCNO coating (figure 1) shows that the coating consists of a cubic TaCN phase (PDF 01-074-5555) and exhibits a strong (220) fiber texture with a texture coefficient TC(220) = 4.3. For the calculation of the texture coefficient, the following peaks were used: (111), (200), (220), (311) and (331). The measured microhardness of the coating was 2940 HV [0.01].

Example 3

A coating according to the present invention was prepared on cemented carbide substrate bodies, as described above, by a CVD process using a reaction gas mixture of 0.44 vol-% $TaCl_5$, 0.13 vol-% $CH_3CN$, 1.09 vol-% HCl, 54.7 vol-% $H_2$ and 43.64 vol-% Ar, a temperature of 800°C and a pressure of 30 mbar for 90 min. The HCl content was added to the gas mixture at the outlet of the external $TaCl_5$ generator, which was operated at 500°C and 40 mbar. The obtained TaCNO coating had a thickness of 12 $\mu$m.

EDX analysis showed peaks of Ta, C, N and a weak peak of O within the deposited TaCNO coating. The XRD of the deposited TaCNO coating (figure 2) shows that the coating consists of a cubic TaCN phase (PDF 01-074-5555) and a lower fraction of the hexagonal $Ta_2C$ phase (PDF 00-032-1280). The coating is nanocrystalline and textureless. The measured microhardness of the coating was 2860 HV [0.01]. A scratch test showed a high critical load of 60 N, which indicates a high layer adhesion as well as a good resistance against abrasive wear of the inventive TaCNO coating.

Example 4

A coating according to the present invention was prepared on cemented carbide substrate bodies, as described above, by a CVD process using a reaction gas mixture of 0.44 vol-% $TaCl_5$, 0.13 vol-% $CH_3CN$, 0.43 vol-% $C_2H_4$, 1.1 vol-% HCl, 54.4 vol-% $H_2$ and 43.5 vol-% Ar, a temperature of 800°C and a pressure of 60 mbar for 60 min. The HCl content was added to the gas mixture at the outlet of the external $TaCl_5$ generator, which was operated at 500°C and 60 mbar. The obtained TaCNO coating had a thickness of 13.4 $\mu$m.

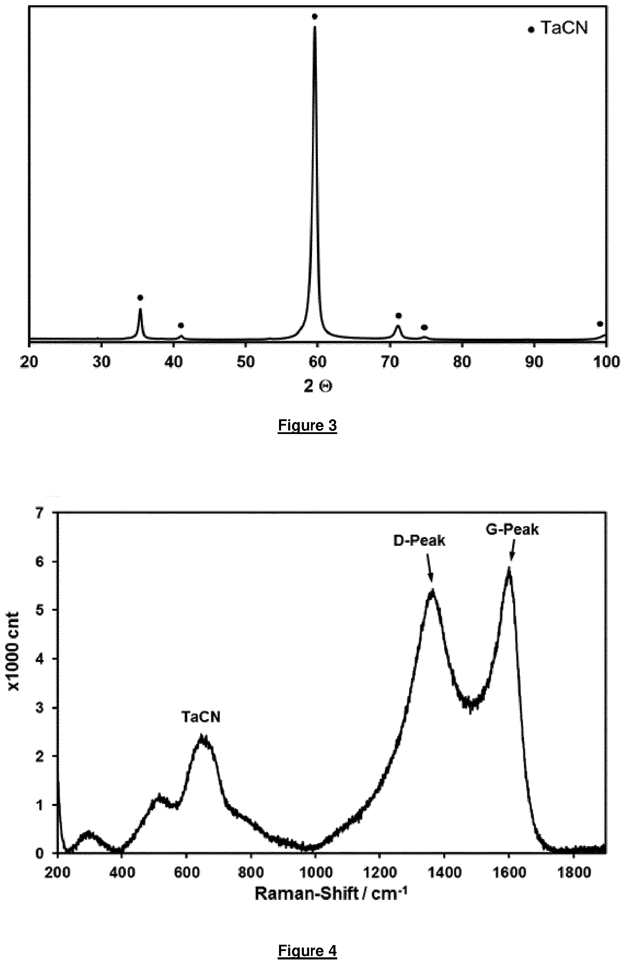

EDX analysis showed peaks of Ta, C, N and a weak peak of O within the deposited TaCNO coating. The XRD of the deposited TaCNO coating (figure 3) shows that the coating consists of a cubic TaCN phase (PDF 01-074-5555) and exhibits a strong (220) fiber texture. The XRD exhibits no peaks of a crystalline carbon phase, but Raman spectroscopy showed two bands at the wavelengths of 1362 $cm^{-1}$ and 1600 $cm^{-1}$ being characteristic for amorphous or nanocrystalline graphitic carbon (figure 4). Accordingly, the coating consisted of a phase mixture of cubic TaCN phase (PDF card 01-074-5555) and amorphous or nanocrystalline graphitic carbon. The measured microhardness of the coating was 2710 HV [0.01]. Thus, the coating exhibited high hardness and, due to the carbon content, beneficial tribological properties.

Example 5

A coating according to the present invention was prepared on cemented carbide substrate bodies, as described above, by a CVD process using a reaction gas mixture of 0.32 vol-% $TaCl_5$, 1.62 vol-% $CH_4$, 81.85 vol-% $H_2$ und 16.21 vol-% Ar, a temperature of 1000°C and a pressure of 300 mbar for 90 min. No HCl was added to the gas mixture. The external $TaCl_5$ generator was operated at 600°C and 300 mbar. The obtained TaCNO coating had a thickness of 8.4 $\mu$m.

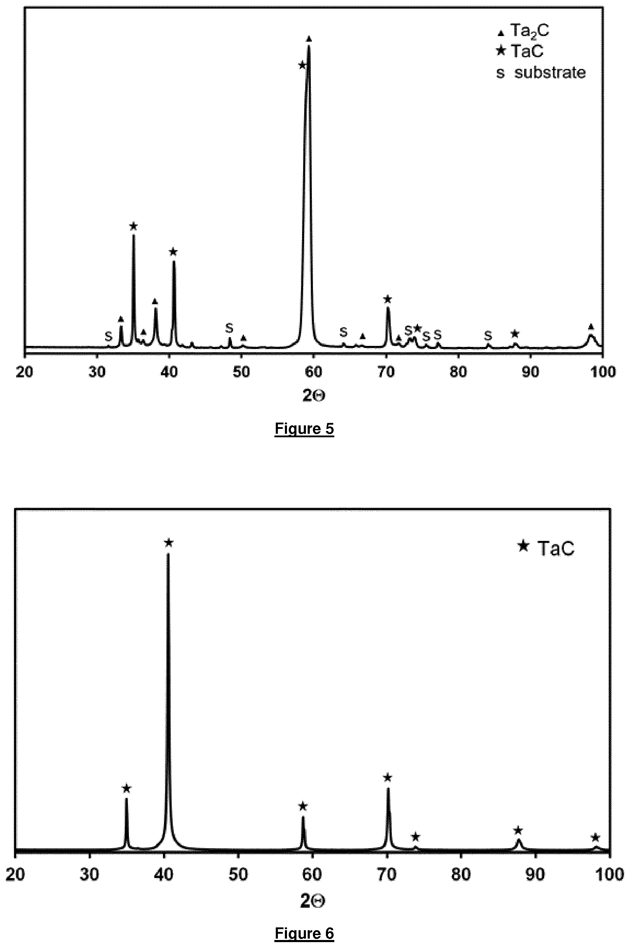

EDX analysis showed only peaks of Ta and C within the deposited TaCNO coating. The XRD of the deposited tantalum carbide coating (figure 5) shows peaks of cubic TaC phase (PDF 00-035-0801) and hexagonal $Ta_2C$ phase (PDF 00-032-1280). The coating is textureless. The measured microhardness of the coating was 2770 HV [0.01]. Thus, the inventive coating exhibited high hardness and, due to the carbon content, beneficial tribological properties.

Example 6

A coating according to the present invention was prepared on cemented carbide substrate bodies, as described above, by a CVD process using a reaction gas mixture of 0.50 vol-% $TaCl_5$, 1.7 vol-% $C_2H_4$, 1.2 vol-% HCl, 72.8 vol-% $H_2$ und 23.8 vol-% Ar, a temperature of 900°C and a pressure of 60 mbar for 90 min. The HCl content was added to the gas mixture at the outlet of the external $TaCl_5$ generator, which was operated at 500°C and 60 mbar. The obtained TaCNO coating had a thickness of 7.5 $\mu$m.

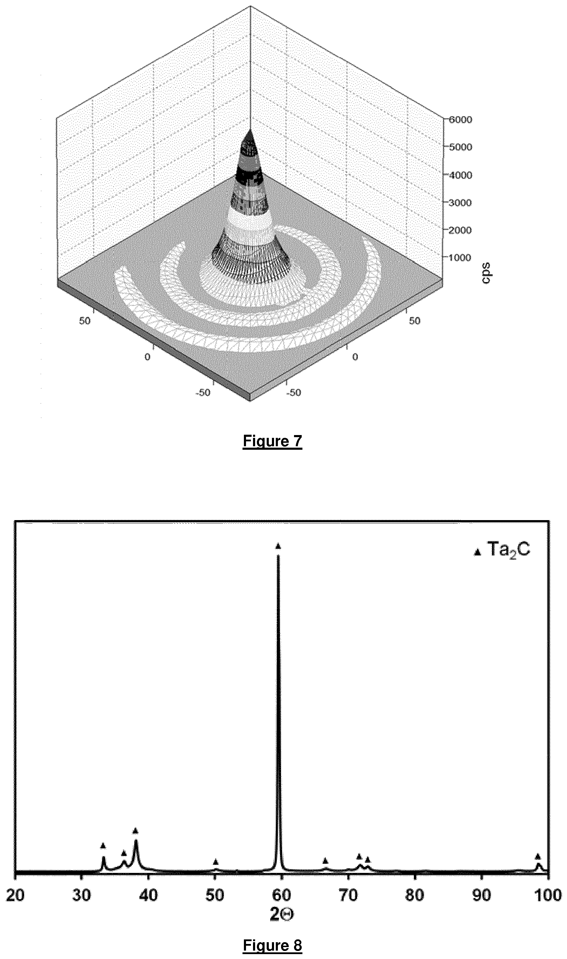

EDX analysis showed only peaks of Ta and C within the deposited TaCNO coating. The XRD of the deposited TaCNO coating (figure 6) shows only peaks of the cubic TaC phase (PDF 00-035-0801). The TaC coating had a strong (200) fiber texture, also shown by pole figure measurement (figure 7). The grain size is below 0.5 $\mu$m. The measured

microhardness of the coating was 2810 HV [0.01]. Thus, the inventive coating contained only the crystalline cubic TaC phase and had a high hardness.

Example 7

Deviating from the previous examples, in this example the coating according to the present invention was deposited on a ceramic substrate of silicon nitride by a CVD process using a reaction gas mixture of 0.50 vol-% $TaCl_5$, 1.2 vol-% $C_2H_4$, 1.2 vol-% HCl, 49.1 vol-% $H_2$ und 48.0 vol-% Ar, a temperature of 900°C and a pressure of 60 mbar for 90 min. The HCl content was added to the gas mixture at the outlet of the external $TaCl_5$ generator, which was operated at 500°C and 60 mbar. The obtained TaCNO coating had a thickness of 6.3 $\mu$m.

EDX analysis showed only peaks of Ta and C and a very weak peak of O within the deposited TaCNO coating. The XRD of the deposited TaCNO coating (figure 8) shows only peaks of the hexagonal $Ta_2C$ phase (PDF 00-032-1280). The (110) peak at a 2θ angle of 60° has a very high intensity indicating a strong (110) fiber texture, and a texture coefficient TC(110) = 5.7 was calculated using the following peaks: (100), (002), (101), (102), (110), (103) and (112). The measured microhardness of the coating was 3070 HV [0.01]. Thus, the inventive coating contained only the crystalline hexagonal $Ta_2C$ phase and had a high hardness.

Example 8

A coating according to the present invention was prepared on cemented carbide substrate bodies, as described above, by a CVD process using a reaction gas mixture of 0.48 vol-% $TaCl_5$, 1.2 vol-% $C_2H_4$, 1.2 vol-% HCl, 25.18 vol-% $H_2$ und 71.94 vol-% Ar, a temperature of 900°C and a pressure of 60 mbar for 90 min. The HCl content was added to the gas mixture at the outlet of the external $TaCl_5$ generator, which was operated at 500°C and 60 mbar. The obtained TaCNO coating had a thickness of 6.8 $\mu$m.

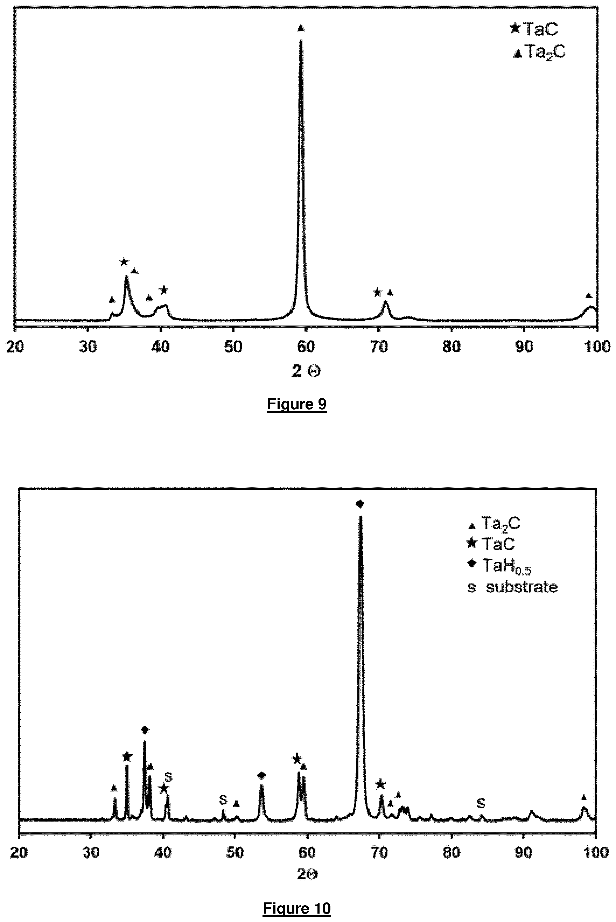

EDX analysis showed only peaks of Ta and C and a very weak peak of O within the deposited TaCNO coating. The XRD of the deposited TaCNO coating (figure 9) reveals strong peaks of the hexagonal $Ta_2C$ phase (PDF 00-032-1280) and weak peaks of the cubic TaC phase (PDF 00-035-0801). The $Ta_2C$ phase exhibit a strong (110) texture The measured microhardness of the coating was 2570 HV [0.01].

Example 9 (comparative)

This example contains a coating beyond the microhardness range of the present invention. But the example illustrates the permissible concentration of hydride phases or hydrogen content.

A coating was prepared on cemented carbide substrate bodies, as described above, by a CVD process using a reaction gas mixture of 0.48 vol-% $TaCl_5$, 0.48 vol-% $CH_4$, 1.21 vol-% HCl, 73.67 vol-% $H_2$ and 24.16 vol-% Ar, a temperature of 1000°C and a pressure of 60 mbar for 90 min. The applied ratio $CH_4 / (CH_4 + TaCl_5)$ = 0.5 which is too low for the manufacture of inventive tantalum carbide coatings. The HCl content was added to the gas mixture at the outlet of the external $TaCl_5$ generator, which was operated at 500°C and 60 mbar. The obtained TaCNO coating had a thickness of 3.8 $\mu$m.

EDX analysis showed only peaks of Ta and C and a very weak peak of O within the deposited TaCNO coating. The XRD of the deposited TaCNO coating (figure 10) shows that the coating consists of a phase mixture of the hexagonal $Ta_2C$ phase (PDF 00-032-1280), cubic TaC phase (PDF 00-035-0801) and tetragonal $TaH_{0.5}$ phase (PDF01-089-4074). The measured microhardness of the coating was 740 HV [0.01].

Example 10 (comparative)

This example describes a coating beyond the range of the present invention. The coating serves as reference for a coating with low adhesion and wear resistance.

A coating was prepared on cemented carbide substrate bodies, as described above, by a CVD process using a reaction gas mixture of 0.43 vol-% $TaCl_5$, 0.17 vol-% $CH_3CN$, 1.09 vol-% HCl, 54.87 vol-% $H_2$ und 43.44 vol-% Ar, a temperature of 700°C and a pressure of 60 mbar for 90 min. The HCl content was added to the gas mixture at the outlet of the external $TaCl_5$ generator, which was operated at 500°C and 60 mbar. The obtained TaCNO coating had a thickness of 9.5 $\mu$m.

EDX analysis revealed peaks of Ta, C, N, O and Cl within the deposited TaCNO coating. The XRD of the deposited TaCNO coating shows that the coating consists of a cubic TaCN phase (PDF 01-074-5555). The coating is nanocrystalline and textureless. The measured microhardness of the coating was 1530 HV [0.01]. A scratch test showed only a low critical load of 18 N which indicates a low layer adhesion as well as a low wear resistance.

**Claims**

1. A coated cutting tool, consisting of a substrate of cemented carbide, cermet, ceramics, or cubic boron nitride and a single layer or multi-layer wear resistant coating and having a total thickness from 1 to 25 $\mu$m, wherein the wear resistant coating comprises a tantalum containing hard material layer comprising one single phase or more than one phase of tantalum compound represented by the general formula $Ta_wC_xN_yO_z$ with w = 1 or 2, $0.2 \leq x \leq 1.1$, $0 \leq y \leq 0.55$ and $0 \leq z \leq 0.2$, x+y+z being within the range from 0.8 - 1.2, and having a hardness of between 2500 HV [0.01] and 3500 HV[0.01].

2. The coated cutting tool according to any of the previous claims, wherein the tantalum containing hard material layer has a chlorine content < 3 at-%, and/or the tantalum containing hard material layer has a hydrogen content < 5 at-%, and/or the tantalum containing hard material layer has a free carbon content < 5 wt%, preferably < 3 wt%, more preferably < 1 wt% and/or the tantalum containing hard material layer has a $TaH_x$ content of < 15 wt%, preferably < 10 wt%, more preferably < 5 wt%.

3. The coated cutting tool according to any of the previous claims, wherein at least one of the $Ta_{w-}C_xN_yO_z$ phases of the tantalum containing hard material layer contains oxygen with $0 < z \leq 0.2$, preferably $0.05 \leq z \leq 0.2$, more preferably $0.1 \leq z \leq 0.2$.

4. The coated cutting tool according to any of the previous claims, wherein the tantalum containing hard material layer contains or consists of one or more tantalum carbide phases $Ta_wC_xN_yO_z$ with y = 0 and z = 0 and/or one or more tantalum carbonitride phases $TaC_xN_yO_z$ with y > 0 and z = 0.

5. The coated cutting tool according to any of the previous claims, wherein the tantalum containing hard material layer contains or consists of one or more tantalum carbide phases $Ta_wC_xN_yO_z$ having a (200) texture with a preferred crystal growth orientation of the {200} plane preferentially growing parallel to the substrate surface, or a (110) texture with a preferred crystal growth orientation of the {110} plane preferentially growing parallel to the substrate surface or a (220) texture with a preferred crystal growth orientation of the {220} plane preferentially growing parallel to the substrate surface.

6. Coated cutting tool according to any of the previous claims, wherein the tantalum containing hard material layer is a multi-layer system consisting of individual sub-layers of $Ta_wC_xN_yO_z$ phases having different stoichiometric coefficients of x, y and z.

7. Coated cutting tool according to any of the previous claims, wherein the tantalum containing hard material layer is combined in a multilayer coating system with one or more hard material layers above the tantalum containing hard material layer and/or between the substrate and the tantalum containing hard material layer, wherein the layers of the multilayer coating consist of one or more carbides, nitrides, oxides, borides or combinations or solid solutions thereof of transition metals selected from one or more of the elements of groups 4 to 6 of the periodic table and/or Al or Si.

8. A method for the production of a coated cutting tool according to any of claims 1 to 7, wherein the tantalum containing layer is deposited by a thermal CVD process at a temperature between 725°C and 1050°C, at a pressure lower than 600 mbar, and from a reaction gas mixture that contains at least $TaCl_5$, $H_2$ and/or noble gas, preferably Ar, and one or more selected from hydrocarbons, organic nitriles and oxygen-containing compounds, preferably selected from $CH_4$, $C_2H_4$, $C_2H_6$, $CH_3CN$, CO and $CO_2$, wherein the reaction gas mixture preferably contains HCl and/or wherein the pressure in the thermal CVD coating process preferably is at least 30 mbar, more preferably at least 40 mbar, wherein the CVD reaction gas mixture contains

   - $TaCl_5$ in an amount of 0.2 to 4 vol-%,
   - HCl in an amount of 0 to 8 vol-%,
   - noble gas, preferably Ar, in an amount of 0 to 75 vol-%,
   - one or more hydrocarbons, organic nitriles and/or oxygen-containing compounds in an amount of 0.03 to 10 vol-%, and
   - balance $H_2$,

   wherein in the CVD reaction gas mixture the vol-% ratio of $H_2$ / $TaCl_5$ is in within the range of 20 to 800, preferably 30 to 500, more preferably 50 to 200, wherein in the CVD reaction gas mixture

- CH$_4$ is selected as hydrocarbon and the vol-% ratio of CH$_4$ / (CH$_4$ + TaCl$_5$) is >0.5, preferably is within the range of 0.55 to 0.95, more preferably is within the range of 0.6 to 0.9, and/or
- the one or more hydrocarbons are selected from C$_2$H$_4$ and C$_2$H$_6$, and the vol-% ratio of hydrocarbons / (hydrocarbons + TaCl$_5$) is in within the range of 0.3 to 0.95, preferably 0.5 to 0.85, and/or
- the organic nitrile is CH$_3$CN, and the vol-% ratio of CH$_3$CN / (CH$_3$CN + TaCl$_5$) is in within the range of 0.1 to 0.5, and/or
- the one or more oxygen-containing compounds are selected from CO and CO$_2$, and the vol-% ratio of oxygen-containing compounds / (oxygen-containing compounds + TaCl$_5$) is in within the range of 0.05 to 0.9, preferably 0.2 to 0.7.

9. The method according to claim 8, wherein the TaCl$_5$ is produced in an external tantalum chloride generator by the reaction of tantalum metal with pure HCl or with a mixture of HCl and a noble gas, preferably Ar, at a temperature between 400°C and 600°C, preferably between 450 and 550 °C and at a process pressure of more than 40 mbar and less than 600 mbar.

10. The method according to any of claims 8 to 9, wherein a proportion or all of the HCl contained in the CVD reaction gas mixture is added at the outlet (exit) of the tantalum chloride generator before the tantalum chloride precursor is mixed with the further constituents of the CVD reaction gas mixture.

**Patentansprüche**

1. Beschichtetes Schneidwerkzeug, welches aus einem Substrat aus Sintercarbid, Cermet, Keramik oder kubischem Bornitrid und einer einlagigen oder mehrlagigen verschleißfesten Beschichtung mit einer Gesamtdicke von 1 bis 25 μm besteht, wobei die verschleißfeste Beschichtung eine Tantal enthaltende Hartmetalllage aufweist, welche zumindest eine einzelne Phase oder mehr als eine Phase einer Tantalverbindung aufweist, welche durch die allgemeine Formel Ca$_w$C$_x$N$_y$O$_z$ beschrieben ist mit w = 1 oder 2, 0,2 ≤ x ≤ 1,1, 0 ≤ y ≤ 0,55 und 0 ≤ z ≤ 0,2, wobei x + y + z in dem Bereich von 0,8-1,2 liegt, und mit einer Härte, die zwischen 2500 HV [0,01] und 3500 HV [0,01] liegt.

2. Beschichtetes Schneidwerkzeug nach einem der vorstehenden Ansprüche, wobei die Tantal enthaltende Hartmetallschicht einen Chlorgehalt < 3 at% hat, und/oder die Tantal enthaltende Hartmetallschicht einen Wasserstoffgehalt < 5 at% hat, und/oder die Tantal enthaltende Hartmetallschicht einen freien Kohlenstoffgehalt < 5 Gew.-%%, vorzugsweise < 3 Gew.-%, bevorzugter < 1 Gew.-% hat und/oder die Tantal enthaltende Hartmetallschicht einen TaH$_x$-Gehalt < 15 Gew.-%, vorzugsweise < 10 Gew.-%, noch bevorzugter < 5 Gew.-% hat.

3. Beschichtetes Schneidwerkzeug nach einem der vorstehenden Ansprüche, wobei zumindest eine der Ta$_w$C$_x$N$_y$O$_z$-Phasen der Tantal enthaltenden Hartmetallschicht Sauerstoff mit 0 < z ≤ 0,2, vorzugsweise 0,05 ≤ z ≤ 0,2, noch bevorzugter 0,1 ≤ z ≤ 0,2 enthält.

4. Beschichtetes Schneidwerkzeug nach einem der vorstehenden Ansprüche, wobei die Tantal enthaltende Hartmetallschicht eine oder mehrere Tantalcarbidphasen Ta$_w$C$_x$N$_y$O$_z$ mit y = 0 und z = 0 und/oder eine oder mehrere Tantalcarbonitridphasen TaC$_x$N$_y$O$_z$ mit y > 0 und z = 0 enthält oder aus diesen besteht.

5. Beschichtetes Schneidwerkzeug nach einem der vorstehenden Ansprüche, wobei die Tantal enthaltende Hartmetallschicht eine oder mehrere Tantalcarbidphasen Ta$_w$C$_x$N$_y$O$_z$ mit einer (200)-Textur mit einer bevorzugten Kristallorientierungsrichtung der {200}-Ebene hat, welche vorzugsweise parallel zu der Substratoberfläche wächst oder eine (110)-Textur mit einer bevorzugten Kristallwachstumsrichtung der {110}-Ebene hat, welche vorzugsweise parallel zur Substratoberfläche wächst oder eine (220)-Textur mit einer bevorzugten Kristallwachstumsrichtung der {220}-Ebene hat, die vorzugsweise parallel zu der Substratfläche aufgewachsen ist.

6. Beschichtetes Schneidwerkzeug nach einem der vorstehenden Ansprüche, wobei die Tantal enthaltende Hartmetalllage ein mehrlagiges System ist, welches aus individuellen Teillagen von Ta$_w$C$_x$N$_y$O$_z$-Phasen besteht, die unterschiedliche stöchiometrische Koeffizienten x, y und z haben.

7. Beschichtetes Schneidwerkzeug nach einem der vorstehenden Ansprüche, wobei die Tantal enthaltende Hartmetallschicht in einem mehrlagigen Beschichtungssystem mit einer oder mehreren Hartmetalllagen über der Tantal enthaltenen Hartmetallschicht und/oder zwischen dem Substrat und der Tantal enthaltenden Hartmetalllage kombiniert ist, wobei die Schichten bzw. Lagen der mehrlagigen Beschichtung aus einem oder mehreren Carbiden,

13

Nitriden, Oxiden, Boriden oder Kombinationen oder festen Lösungen derselben von Übergangsmetallen bestehen, die aus einem oder mehreren der Elemente der Gruppen 4 bis 6 des Periodensystems und/oder aus Al oder Si ausgewählt sind.

**8.** Verfahren zur Herstellung eines beschichteten Schneidwerkzeuges nach einem der Ansprüche 1 bis 7, wobei die Tantal enthaltende Schicht durch ein thermisches CVD-Verfahren bei einer Temperatur zwischen 725 °C und 1050 °C abgeschieden wird, bei einem Druck niedriger als 600 mbar, und aus einer Reaktionsgasmischung, welche zumindest $TaCl_5$, $H_2$ und/oder Edelgas, vorzugsweise Ar, enthält, sowie eine oder mehrere, ausgewählt aus Kohlenwasserstoffen, organischen Nitrilen und Sauerstoff enthaltende Verbindungen, vorzugsweise ausgewählt aus $CH_4$, $C_2H_6$, $CH_3CN$, CO und $CO_2$, wobei die Reaktionsgasmischung vorzugsweise HCl enthält und/oder wobei der Druck in dem thermischen CVD-Beschichtungsverfahren vorzugsweise zumindest 30 mbar beträgt, noch bevorzugter zumindest 40 mbar beträgt, wobei die CVD-Reaktionsgasmischung enthält

- $TaCl_5$ in einer Menge von 0,2 bis 4 vol-%,
- HCl in einer Menge von 0 bis 8 vol-%,
- Edelgas, vorzugsweise Ar in einer Menge von 0 bis 75 vol-%,
- eine oder mehrere Kohlenwasserstoffe, organische Nitrile und/oder Sauerstoff enthaltende Verbindungen in einer Menge von 0,03 bis 10 vol-%, und
- im Übrigen $H_2$,

wobei in der Reaktionsgasmischung das Volumenverhältnis von $H_2/TaCl_5$ innerhalb des Bereiches von 20 bis 800 liegt, vorzugsweise 30 bis 500, noch bevorzugter 50 bis 200, wobei in der CVD-Reaktionsgasmischung

- $CH_4$ als Kohlenwasserstoff gewählt wird und das Volumenverhältnis von $CH_4/ (CH_4 + TaCl_5) > 0,5$ beträgt, vorzugsweise in dem Bereich von 0,55 bis 0,95 liegt und noch bevorzugter innerhalb des Bereiches von 0,6 bis 0,9 liegt, und/oder
- der eine oder die mehreren Kohlenwasserstoffe ausgewählt sind aus $C_2H_4$ und $C_2H_6$, und das Volumenverhältnis von Kohlenwasserstoffen / (Kohlenwasserstoffe + $TaCl_5$) innerhalb des Bereiches von 0,3 bis 0,95, vorzugsweise 0,05 bis 0,85 liegt, und/oder
- das organische Nitril $CH_3CN$ ist und das Volumenverhältnis von $CH_3CN / (CH_3CN + TaCl_5)$ innerhalb des Bereiches von 0,1 bis 0,5 liegt und/oder
- die eine oder die mehreren Sauerstoff enthaltenden Verbindungen ausgewählt sind aus CO und $CO_2$, und das prozentuale Volumenverhältnis von Sauerstoff enthaltenden Verbindungen / (Sauerstoff enthaltenden Verbindungen + $TaCl_5$) innerhalb des Bereiches von 0,05 bis 0,9, vorzugsweise innerhalb von 0,2 bis 0,7 liegt.

**9.** Verfahren nach Anspruch 8, wobei das $TaCl_5$ in einem externen Tantalchloridgenerator durch die Reaktion von Tantalmetall mit reinem HCL oder mit einer Mischung aus HCl und einem Edelgas, vorzugsweise Ar, bei einer Temperatur zwischen 400 °C und 600 °C, vorzugsweise zwischen 450 °C und 550 °C und einem Prozessdruck von mehr als 40 mbar und weniger als 600 mbar produziert wird.

**10.** Verfahren nach einem der Ansprüche 8 oder 9, wobei weil ein Teil des oder das gesamte HCl, welches in der CVD-Reaktionsgasmischung enthalten ist, am Ausgang (Austritt) des Tantalchloridgenerators hinzugefügt wird bevor der Tantalchloridvorläufer mit den weiteren Bestandteilen der CVD-Reaktionsgasmischung vermischt wird.

## Revendications

**1.** Outil de coupe revêtu, constitué d'un substrat de carbure cémenté, de cermet, de céramique, ou de nitrure de bore cubique et d'un revêtement monocouche ou multicouche résistant à l'usure et présentant une épaisseur totale allant de 1 à 25 μm, où le revêtement résistant à l'usure comprend une couche de matériau dur contenant du tantale comprenant une seule phase ou plusieurs phases de composé de tantale représenté par la formule générale $Ta_wC_xN_yO_z$ avec w = 1 ou 2, $0,2 \leq x \leq 1,1$, $0 \leq y \leq 0,55$ et $0 \leq z \leq 0,2$, x + y +z étant dans la plage allant de 0,8 à 1,2, et présentant une dureté comprise entre 2 500 HV [0,01] et 3 500 HV [0,01].

**2.** Outil de coupe revêtu selon la revendication précédente, dans lequel la couche de matériau dur contenant du tantale présente une teneur en chlore < 3 % at., et/ou
la couche de matériau dur contenant du tantale présente une teneur en hydrogène < 5 % at., et/ou
la couche de matériau dur contenant du tantale présente une teneur en carbone libre < 5 % en poids, de préférence < 3 % en poids, de façon davantage préférée < 1 % en poids et/ou
la couche de matériau dur contenant du tantale présente une teneur en $TaH_x$ < 15 % en poids, de préférence < 10 % en poids, de façon davantage préférée < 5 % en poids.

3. Outil de coupe revêtu selon l'une quelconque des revendications précédentes, dans lequel au moins l'une des phases de $Ta_wC_xN_yO_z$ de la couche de matériau dur contenant du tantale contient de l'oxygène avec $0 < z \leq 0,2$, de préférence $0,05 \leq z \leq 0,2$, de façon davantage préférée $0,1 \leq z \leq 0,2$.

4. Outil de coupe revêtu selon l'une quelconque des revendications précédentes, dans lequel la couche de matériau dur contenant du tantale contient ou est constituée d'une ou de plusieurs phases de carbure de tantale $Ta_wC_xN_yO_z$ avec $y = 0$ et $z = 0$ et/ou d'une ou de plusieurs phases de carbonitrure de tantale $Ta_wC_xN_yO_z$ avec $y > 0$ et $z = 0$.

5. Outil de coupe revêtu selon l'une quelconque des revendications précédentes, dans lequel la couche de matériau dur contenant du tantale contient ou est constituée d'une ou de plusieurs phases de carbure de tantale $Ta_wC_xN_yO_z$ présentant une texture (200) avec une orientation de croissance cristalline préférée du plan {200} croissant préférentiellement parallèlement à la surface de substrat, ou une texture (110) avec une orientation de croissance cristalline préférée du plan {110} croissant préférentiellement parallèlement à la surface de substrat ou une texture (220) avec une orientation de croissance cristalline préférée du plan {220} croissant préférentiellement parallèlement à la surface de substrat.

6. Outil de coupe revêtu selon l'une quelconque des revendications précédentes, dans lequel la couche de matériau dur contenant du tantale est un système multicouche constitué de sous-couches individuelles de phases de $Ta_wC_xN_yO_z$ présentant des coefficients stœchiométriques différents de x, y et z.

7. Outil de coupe revêtu selon l'une quelconque des revendications précédentes, dans lequel la couche de matériau dur contenant du tantale est combinée dans un système de revêtement multicouche avec une ou plusieurs couches de matériau dur au-dessus de la couche de matériau dur contenant du tantale et/ou entre le substrat et la couche de matériau dur contenant du tantale, où les couches du revêtement multicouche sont constituées d'un ou de plusieurs carbures, nitrures, oxydes, borures ou combinaisons ou solutions solides de ceux-ci de métaux de transition sélectionnés parmi un ou plusieurs des éléments des groupes 4 à 6 du tableau périodique et/ou Al ou Si.

8. Procédé de production d'un outil de coupe revêtu selon l'une quelconque des revendications 1 à 7, dans lequel la couche contenant du tantale est déposée par un procédé de dépôt chimique en phase vapeur (CVD) thermique à une température comprise entre 725 °C et 1 050 °C, à une pression inférieure à 600 mbar, et à partir d'un mélange gazeux réactionnel qui contient au moins du $TaCl_5$, du $H_2$ et/ou un gaz noble, de préférence de l'Ar, et un ou plusieurs composés sélectionnés parmi des hydrocarbures, des nitriles organiques et des composés contenant de l'oxygène, de préférence sélectionnés parmi $CH_4$, $C_2H_4$, $C_2H_6$, $CH_3CN$, CO et $CO_2$, où le mélange gazeux réactionnel contient de préférence du HCl et/ou où la pression lors du procédé de dépôt CVD thermique est de préférence d'au moins 30 mbar, de façon davantage préférée d'au moins 40 mbar, où le mélange gazeux réactionnel de CVD contient

- du $TaCl_5$ selon une proportion allant de 0,2 à 4 % en volume,
- du HCl selon une proportion allant de 0 à 8 % en volume,
- un gaz noble, de préférence l'Ar, selon une proportion allant de 0 à 75 % en volume,
- un ou plusieurs hydrocarbures, nitriles organiques et/ou composés contenant de l'oxygène selon une proportion allant de 0,03 à 10 % en volume, et
- le reste étant du $H_2$,

où dans le mélange gazeux réactionnel de CVD, le rapport de pourcentage volumique de $H_2/TaCl_5$ se situe dans la plage allant de 20 à 800, de préférence allant de 30 à 500, de façon davantage préférée allant de 50 à 200, où dans le mélange gazeux réactionnel de CVD

- le $CH_4$ est sélectionné à titre d'hydrocarbure et le rapport de pourcentage volumique de $CH_4/(CH_4 + TaCl_5)$ est > 0,5, de préférence se situe dans la plage allant de 0,55 à 0,95, de façon davantage préférée se situe dans la plage allant de 0,6 à 0,9, et/ou
- les un ou plusieurs hydrocarbures sont sélectionnés parmi le $C_2H_4$ et le $C_2H_6$, et le rapport de pourcentage volumique de hydrocarbures/(hydrocarbures + $TaCl_5$) se situe dans la plage allant de 0,3 à 0,95, de préférence allant de 0,5 à 0,85, et/ou
- le nitrile organique est le $CH_3CN$, et le rapport de pourcentage volumique de $CH_3CN /(CH_3CN + TaCl_5)$ se

situe dans la plage allant de 0,1 à 0,5, et/ou

- les un ou plusieurs composés contenant de l'oxygène sont sélectionnés parmi le CO et le $CO_2$ et le rapport de pourcentage volumique de composés contenant de l'oxygène/(composés contenant de l'oxygène + $TaCl_5$) se situe dans la plage allant de 0,05 à 0,9, de préférence allant de 0,2 à 0,7.

9. Procédé selon la revendication 8, dans lequel le $TaCl_5$ est produit dans un générateur de chlorure de tantale externe par la réaction du métal de tantale avec du HCl pur ou avec un mélange de HCl et d'un gaz noble, de préférence l'Ar, à une température comprise entre 400 °C et 600 °C, de préférence entre 450 °C et 550 °C, et à une pression de procédé supérieure à 40 mbar et inférieure à 600 mbar.

10. Procédé selon l'une quelconque des revendications 8 et 9, dans lequel une fraction ou la totalité du HCl contenu dans le mélange gazeux réactionnel de CVD est ajoutée au niveau de la sortie du générateur de chlorure de tantale avant que le précurseur de chlorure de tantale ne soit mélangé avec les autres constituants du mélange gazeux réactionnel de CVD

Figure 1

Figure 2

Figure 3

Figure 4

Figure 5

Figure 6

Figure 7

Figure 8

**Figure 9**

**Figure 10**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1852407 A1
- WO 9924634 A
- US 4138512 A

### Non-patent literature cited in the description

- **A. LEVESQUE ; A. BOUTEVILLE.** *J. Phys.,* 2001, vol. 11, Pr3-907, 913
- **CHEN, ZHAO-KE ; XIONG, XIANG.** Texture structure and ablation behavior of TaC on carbon/carbon composites. *Applied Surface Science,* 2010, vol. 257, 656-661
- **CHEN, ZHAO-KE ; XIONG, XIANG ; LONG, YING.** Influence of TaCl5 partial pressure on texture structure of TaC coating deposited by chemical vapor deposition. *Applied Surface Science,* 2011, vol. 257, 4044-4050
- **CHEN, ZHAO-KE et al.** Phase composition and morphology of TaC coating on carbon fibers by chemical vapor infiltration. *Thin Solid Films,* 2008, vol. 516, 8248-8254
- **ZHAO-KE et al.** *Applied Surface Science,* vol. 257
- **YING LONG et al.** *Materials letters,* vol. 121